# EUROPEAN PATENT APPLICATION

(11) **EP 4 708 356 A1**
(43) Date of publication of application: **11.03.2026**
(21) Application number: 24839681.4
(22) Date of filing: 05.07.2024
(51) Int. Cl.: H01L 23/13, H01L 23/12, H05K 3/38

(54) **CERAMIC CIRCUIT BOARD AND METHOD FOR MANUFACTURING SAME**

(30) Priority: 07.07.2023 JP 2023111831
(71) Applicant: Niterra Materials Co., Ltd., Yokohama-shi, Kanagawa 235-0032 (JP)
(72) Inventor: ODA, Tatsuya, Yokohama-shi, Kanagawa 235-0032 (JP); KATO, Hiromasa, Yokohama-shi, Kanagawa 235-0032 (JP); SATO, Hideki, Yokohama-shi, Kanagawa 235-0032 (JP)
(74) Representative: Hoffmann Eitle
(86) International application number: PCT/JP2024/024457
(87) International publication number: WO 2025/013789

(57) **Abstract**

A ceramic circuit board according to an embodiment includes a ceramic substrate and a metal circuit. The metal circuit is bonded to a first surface of the ceramic substrate via an active metal brazing material layer. A thickness of the metal circuit is not less than 1 mm. The metal circuit has a through-hole extending through the metal circuit along a first direction perpendicular to the first surface. A portion of the first surface overlaps the through-hole in the first direction. The active metal brazing material layer is present at the portion of the first surface.

## Description

### [Technical Field]

Embodiments relate generally to a ceramic circuit board and a method for manufacturing a ceramic circuit board.

### [Background Art]

A ceramic circuit board is used in a semiconductor device in which a semiconductor element such as a power element or the like is mounted. A ceramic substrate and a metal circuit part are bonded to each other via a bonding layer using a brazing material, etc. The bonding strength and heat cycle characteristics are improved thereby. As reliability is increased, ceramic circuit boards are being used in inverters of automobiles (including electric vehicles), electric railway vehicles, solar power generation equipment, industrial machinery, etc. In a semiconductor device such as a power module or the like, a semiconductor element is mounted to a circuit part. Also, wire bonding or bonding of a metal terminal to the circuit part may be performed to electrically connect the semiconductor element. The semiconductor element, the wire bonding, the metal terminal, etc., are bonded to the circuit part in the manufacture of the semiconductor device.

With the advent of power semiconductors such as SiC, GaN, etc., there has been an increasing number of cases where larger than conventional capacities of electricity are conducted by metal circuits. The electrical capacity of fine wire bonding is insufficient. Therefore, metal circuits and external devices are electrically connected with metal leadframes. Also, heat is generated by semiconductor elements when large currents flow in metal circuits. To improve the heat dissipation, there is a tendency to make metal circuits thicker and make ceramic substrates thinner. There is also a tendency to make ceramic substrates thinner and metal circuits thicker as power modules become smaller and lighter with higher-density mounting.

There are cases where a ceramic circuit board includes a metal leadframe. A ceramic circuit board that includes a metal leadframe may be included as part of a semiconductor device. In such a case, the ceramic circuit board can transmit and receive electrical signals between an external device via the metal leadframe. Instead of a flat plate-shaped metal leadframe, there are also cases where a pin-shaped metal leadframe is used. Patent Literature 1 discusses a method of forming a hole in a metal member and bonding a pin-shaped leadframe inside the hole. According to Patent Literature 1, a backing plate having a via formed therein can be bonded to a sapphire sensing diaphragm by a bonding pad to form an electrical lead.

Ceramic circuit boards in which holes are formed in metal circuits also are discussed, although not for the purpose of bonding pin-shaped leadframes (Patent Literatures 2 and 3). According to Patent Literature 2, a through-hole is formed simultaneously with forming a circuit part and a heat dissipation part by etching. According to Patent Literature 3, a copper plate in which a through-hole is formed by stamping is bonded to a ceramic substrate by DBC.

### [Prior Art Documents]

### [Patent Literature]

Patent Literature 1: JP-A 2006-529027 (Kohyo)
Patent Literature 2: JP-A 2013-175525 (Kokai)
Patent Literature 3: JP-A S63-239964 (Kokai)

### [Summary of Invention]

### [Problem to be Solved by the Invention]

In a conventional metal circuit ceramic substrate, a pattern circuit is formed by etching. For example, a brazing material that includes an active metal is printed on a ceramic substrate. A metal plate is arranged on the brazing material. A metal bonding plate is made by heating the ceramic substrate and the metal plate. Subsequently, a resist is coated onto the metal bonding plate. A pattern is formed in the metal plate by etching the metal plate by using the resist as a mask.

A hole is formed in the metal circuit when a metal pin is to be included in the ceramic circuit board. A ceramic circuit board that includes a metal pin is manufactured by inserting the metal pin into a hole and by fixing the metal pin. In such a case, a method may be considered in which the hole for fixing the metal pin is formed by etching. When, however, the thickness of the metal circuit is greater than 1 mm, it may be difficult to form a hole extending through the metal circuit by etching. Therefore, conventionally, a hole that does not completely extend through the metal circuit is formed, and the metal pin is bonded inside the hole. When, however, the hole is shallow, the bonding area between the metal circuit and the metal pin is small, and there is a possibility that the metal pin may not be sufficiently fixed.

Embodiments are directed to solve such problems, and to provide a ceramic circuit board that enables increased bonding strength between the metal circuit and the metal pin.

### [Means for Solving the Problem]

A ceramic circuit board according to an embodiment includes a ceramic substrate and a metal circuit. The metal circuit is bonded to a first surface of the ceramic substrate via an active metal brazing material layer. A thickness of the metal circuit is not less than 1 mm. The metal circuit has a through-hole extending through the metal circuit along a first direction perpendicular to the first surface. A portion of the first surface overlaps the through-hole in the first direction. The active metal brazing material layer is present at the portion of the first surface.

### [Brief Description of Drawings]

[FIG. 1]

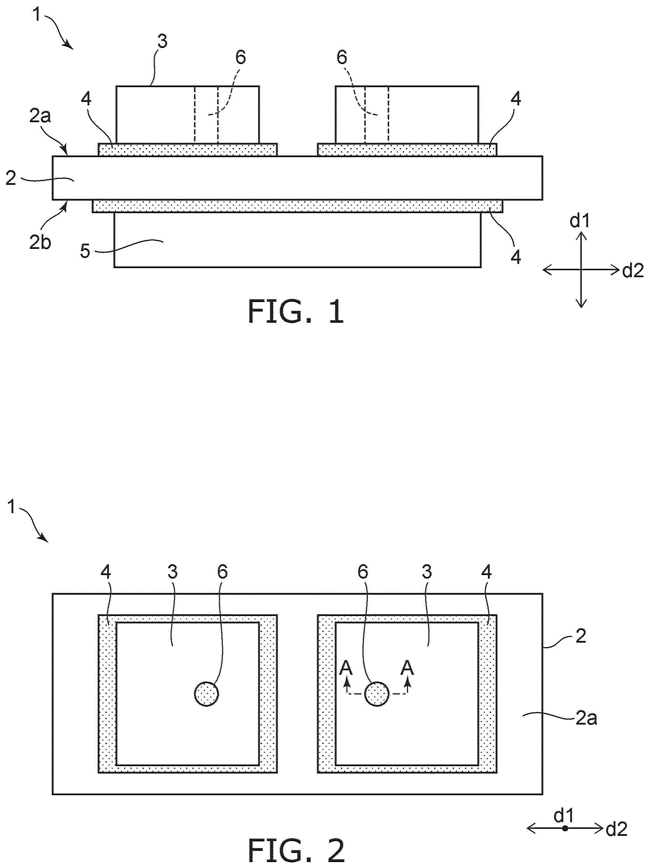

   FIG. 1 is a side view showing an example of a ceramic circuit board according to an embodiment.
[FIG. 2]
   FIG. 2 is a top view showing an example of the ceramic circuit board according to the embodiment.
[FIG. 3]

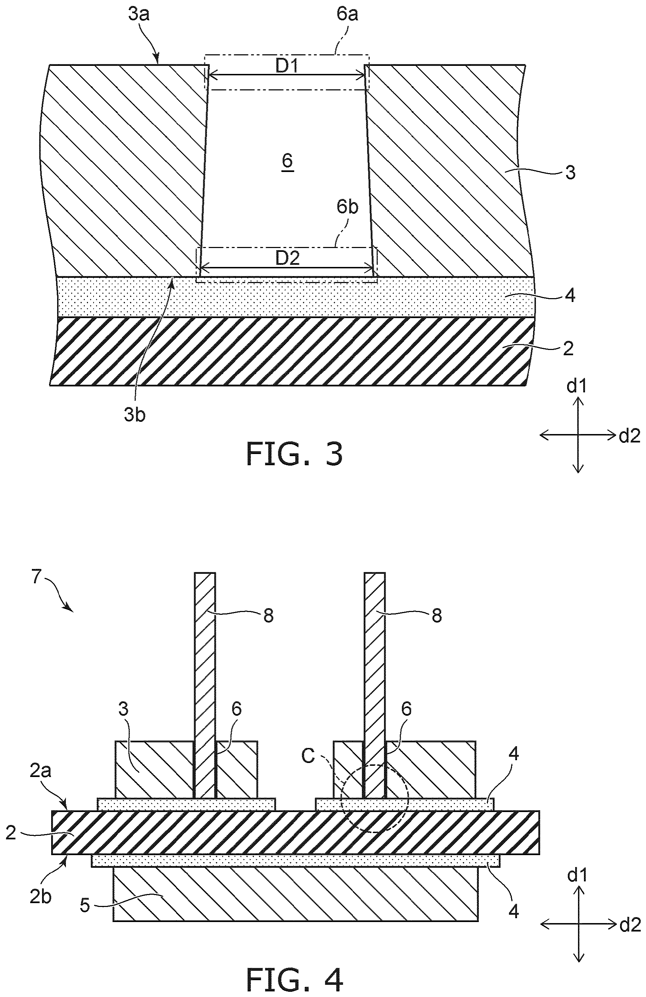

   FIG. 3 is an enlarged cross-sectional view of a metal pin bonding portion according to an embodiment.
[FIG. 4]
   FIG. 4 is a cross-sectional view showing another example of a ceramic circuit board according to an embodiment.
[FIG. 5]

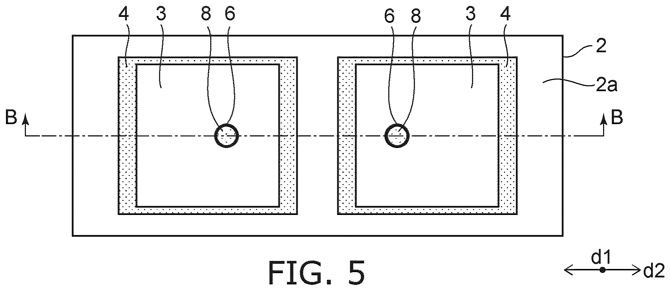

   FIG. 5 is a plan view showing the other example of the ceramic circuit board according to the embodiment.
[FIG. 6]

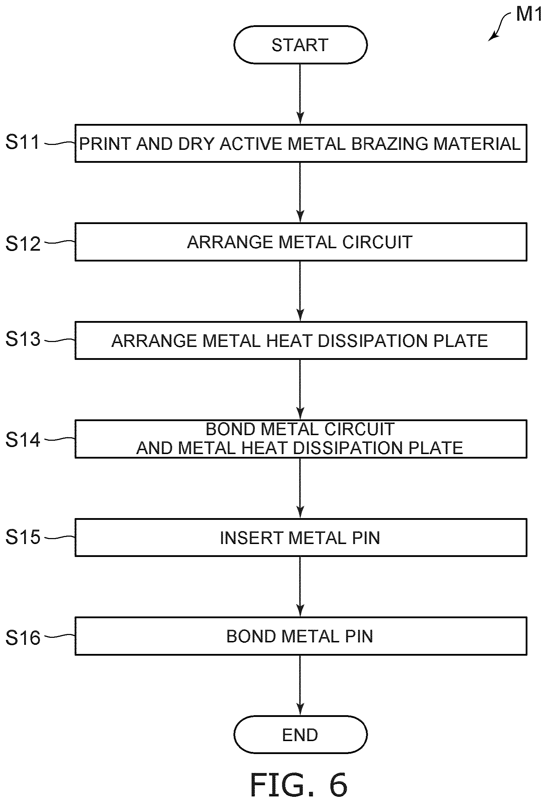

   FIG. 6 is a flowchart showing an example of a method for manufacturing a ceramic circuit board according to an embodiment.
[FIG. 7]

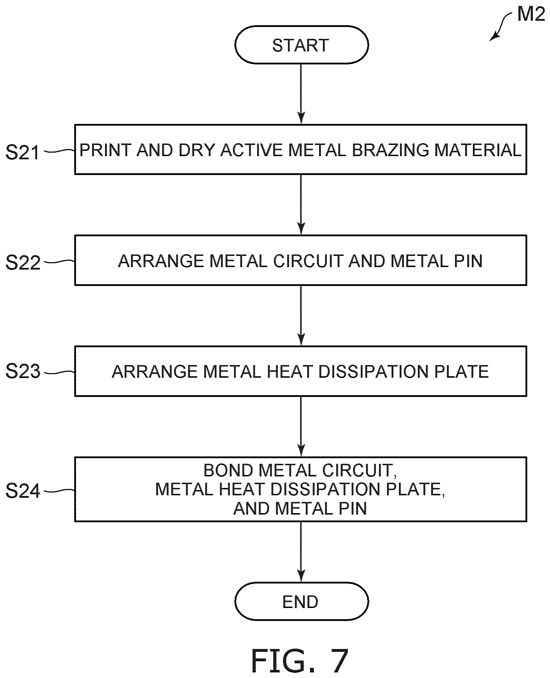

   FIG. 7 is a flowchart showing another example of a method for manufacturing a ceramic circuit board according to an embodiment.
[FIG. 8]

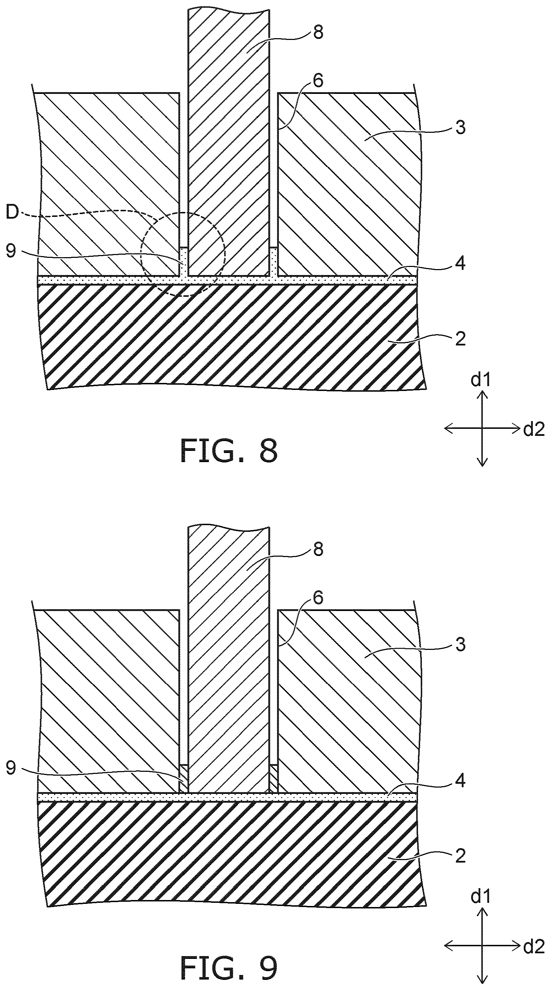

   FIG. 8 is an enlarged cross-sectional view of a metal pin bonding portion according to an embodiment.
[FIG. 9]
   FIG. 9 is an enlarged cross-sectional view of a metal pin bonding portion according to an embodiment.
[FIG. 10]

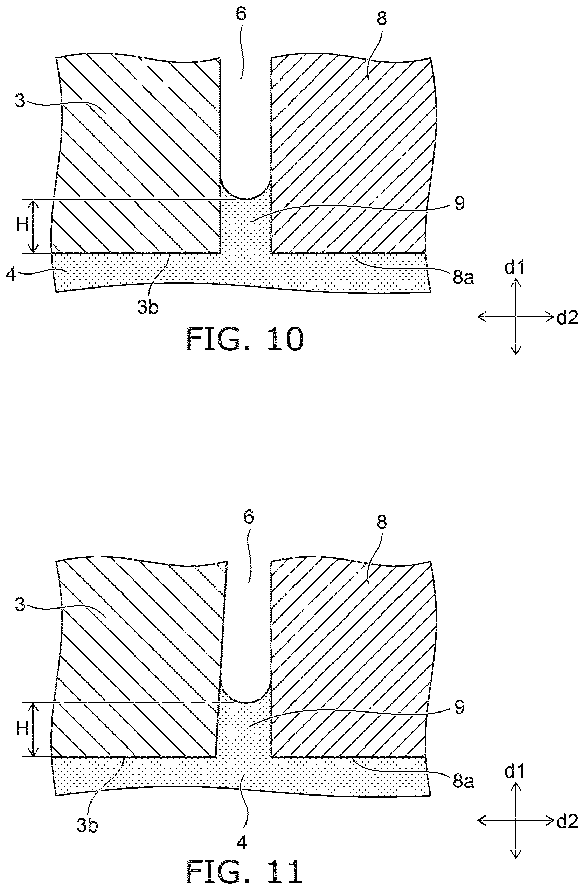

   FIG. 10 is an enlarged cross-sectional view of a metal pin bonding portion according to an embodiment.
[FIG. 11]
   FIG. 11 is an enlarged cross-sectional view of a metal pin bonding portion according to an embodiment.
[FIG. 12]

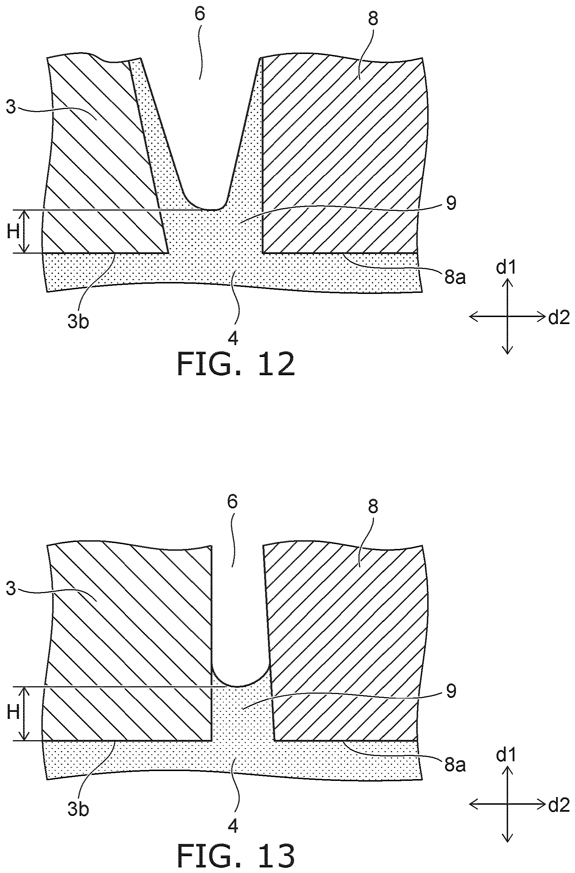

   FIG. 12 is an enlarged cross-sectional view of a metal pin bonding portion according to a comparative example.
[FIG. 13]
   FIG. 13 is an enlarged cross-sectional view of a metal pin bonding portion according to an embodiment.
[FIG. 14]

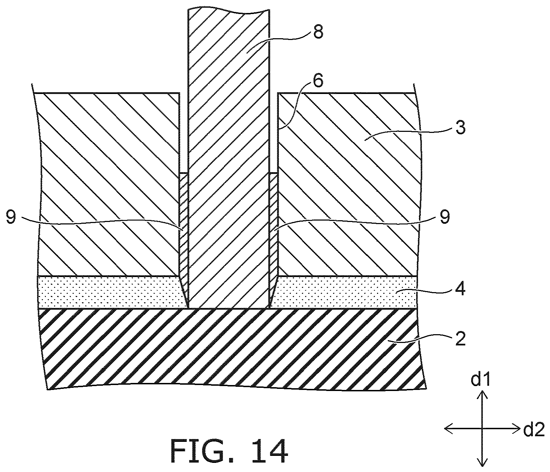

   FIG. 14 is an enlarged cross-sectional view of a metal pin bonding portion according to a comparative example.

### [Description of Embodiments]

A ceramic circuit board according to an embodiment includes a ceramic substrate and a metal circuit. The metal circuit is bonded to a first surface of the ceramic substrate via an active metal brazing material layer. A thickness of the metal circuit is not less than 1 mm. The metal circuit has a through-hole extending through the metal circuit along a first direction perpendicular to the first surface. A portion of the first surface overlaps the through-hole in the first direction. The active metal brazing material layer is present at the portion of the first surface.

FIG. 1 is a side view showing an example of a ceramic circuit board according to an embodiment. In FIG. 1, 1 is a ceramic circuit board, 2 is a ceramic substrate, 3 is a metal circuit, 4 is an active metal brazing material layer, and 5 is a metal heat dissipation plate.

The ceramic substrate 2 has an upper surface 2a (a front surface, a first surface) and a lower surface 2b (a back surface, a second surface). The upper surface 2a and the lower surface 2b are substantially parallel. The metal circuit 3 is bonded to the upper surface 2a via the active metal brazing material layer 4. The metal heat dissipation plate 5 is bonded to the lower surface 2b via the active metal brazing material layer 4. The metal circuit 3 has a through-hole 6 illustrated by broken lines. The through-hole 6 extends through the metal circuit 3 in a first direction d1 perpendicular to the upper surface 2a and the lower surface 2b. Herein, the direction from the ceramic substrate 2 toward the metal circuit 3 is referred to as "up", and the direction from the ceramic substrate 2 toward the metal heat dissipation plate 5 is referred to as "down". These directions are based on the positional relationship between the ceramic substrate 2, the metal circuit 3, and the metal heat dissipation plate 5, and are independent of the direction of gravity.

In the example of FIG. 1, multiple metal circuits 3 are bonded to the upper surface 2a respectively via the multiple active metal brazing material layers 4. One metal heat dissipation plate 5 is bonded to the lower surface 2b via one active metal brazing material layer 4. The structure of the ceramic circuit board 1 according to the embodiment is not limited to the illustrated example. For example, one, three, or more metal circuits 3 may be bonded to the upper surface 2a. The through-hole 6 may be formed in each metal circuit 3, or may be formed in only some of the multiple metal circuits 3. Two or more through-holes 6 may be formed in one metal circuit 3. Two or more metal heat dissipation plates 5 may be bonded to the lower surface 2b respectively via two or more active metal brazing material layers 4. The metal heat dissipation plate 5 may have a circuit configuration; and the metal heat dissipation plate 5 may be used as a metal circuit. In such a case, the through-hole 6 may be formed in the metal heat dissipation plate 5.

It is favorable for the ceramic substrate 2 to be one of a silicon nitride substrate, an aluminum nitride substrate, or an aluminum oxide substrate. An Alusil substrate is an example of one type of aluminum oxide substrate. Alusil is a sintered body with 20 to 80 wt% aluminum oxide and a remainder of zirconium oxide. The three-point bending strength of an aluminum nitride substrate or an aluminum oxide substrate is about 300 to 450 MPa. The strength of an Alusil substrate also is about 550 MPa. The three-point bending strength of a silicon nitride substrate is not less than 600 MPa, and can be further increased to be not less than 700 MPa. The thermal conductivity of a silicon nitride substrate is not less than 50 W/m·K, and can be further increased to be not less than 80 W/m·K. In recent years, there is a silicon nitride substrate that has both high strength and high thermal conductivity.

It is favorable for the thickness of the ceramic substrate 2 to be not more than 0.7 mm. By making the ceramic substrate 2 thin, the heat dissipation of the ceramic circuit board 1 is improved. The "thickness" refers to the dimension in the first direction d1. The ceramic substrate 2 may be a single plate, or may have a three-dimensional structure (e.g., a multilayer structure). The lower limit of the thickness is not particularly set, but is favorably not less than 0.1 mm. This is to ensure the electrical insulation of the ceramic substrate 2.

A silicon nitride substrate has high strength. Therefore, a silicon nitride substrate can be made thin while maintaining the necessary strength. As a result, the heat dissipation can be improved. It is therefore favorable for the ceramic substrate 2 to be a silicon nitride substrate. It is favorable for the thickness of the ceramic substrate 2 to be not more than 0.635 mm, and more favorably not more than 0.3 mm.

FIG. 2 is a plan view showing an example of the ceramic circuit board according to the embodiment.

As shown in FIG. 2, a portion of the upper surface 2a overlaps the through-hole 6 in the first direction d1. In the ceramic circuit board 1, the active metal brazing material layer 4 is present also at the portion of the upper surface 2a. For example, when the ceramic circuit board 1 is viewed in plan, the active metal brazing material layer 4 is visible at the bottom of the through-hole 6.

FIG. 3 is an enlarged cross-sectional view showing the through-hole vicinity. FIG. 3 corresponds to an A-A cross-sectional view of FIG. 2. As shown in FIG. 3, the through-hole 6 includes a first end portion 6a positioned at an upper surface 3a of the metal circuit 3, and a second end portion 6b facing the active metal brazing material layer 4. It is favorable for the ratio (*D2*/*D1*) of a dimension D2 in a second direction d2 of the second end portion 6b to a dimension D1 in the second direction d2 of the first end portion 6a to be greater than 1.00 and not more than 1.10. The second direction d2 is perpendicular to the first direction d1. For example, the dimension in the second direction d2 of the through-hole 6 gradually decreases away from the ceramic substrate 2.

A metal pin can be inserted into the through-hole 6. The inserted metal pin is bonded to the ceramic substrate 2 and the metal circuit 3. When the dimension D1 is greater than the dimension D2, the gap between the metal pin and the side surface of the through-hole 6 at the second end portion 6b is larger than the gap between the metal pin and the side surface of the through-hole 6 at the first end portion 6a. By increasing the gap at the second end portion 6b, a brazing material more easily penetrates the gap between the metal pin and the side surface of the through-hole 6. The volume of the brazing material located in the gap between the metal pin and the side surface of the through-hole 6 can be increased, and the bonding strength of the metal pin can be increased. Also, it is favorable for the dimension D2 to be not more than 1.10 times the dimension D1, and for the dimension D2 not to be too large relative to the dimension D1. By setting the dimension D2 to be not more than 1.10 times the dimension D1, the gap between the metal pin and the side surface of the through-hole 6 is reduced, and the metal pin is easily fixed. Also, the metal pin can be prevented from tilting with respect to the first direction d1.

The dimensions D1 and D2 are measured by the following procedure. First, the ceramic circuit board 1 is cut substantially perpendicular to the upper surface 3a of the metal circuit 3. The cross section is imaged with an optical microscope or a scanning electron microscope (SEM). The photograph that is obtained is enlarged. A dimension at the vicinity of the upper surface 3a of the metal circuit 3 is measured as the dimension D1. A dimension at the vicinity of a lower surface 3b of the metal circuit 3 is measured as the dimension D2. The lower surface 3b also is a bonding surface with the active metal brazing material layer 4. The location at which the dimension D1 is measured is selected inside a range within 5% of the thickness of the metal circuit 3 from the upper surface 3a. The location at which the dimension D2 is measured is selected inside a range within 5% of the thickness of the metal circuit 3 from the lower surface 3b. At this time, the distance in the first direction d1 between the upper surface 3a and the measurement location of the dimension D1 is set to be equal to the distance in the first direction d1 between the lower surface 3b and the measurement location of the dimension D2.

The direction in which the dimensions D1 and D2 are measured is arbitrarily selectable as long as the direction is perpendicular to the first direction d1. For example, when the through-hole 6 is elliptical when viewed in plan, the ceramic circuit board 1 is cut through the center of the through-hole 6 and parallel to the minor-diameter direction. When the through-hole 6 is polygonal when viewed in plan, the ceramic circuit board 1 is cut in a direction passing through the center of the through-hole 6 so that the dimension of the through-hole 6 is shortest. For example, when the through-hole 6 is rectangular when viewed in plan, the ceramic circuit board 1 is cut through the center of the through-hole 6 and parallel to the short-side direction. The dimensions D1 and D2 are measured at the cut surface.

Methods of forming the metal circuit 3 may be the following methods. In a first method, the metal circuit 3 in which the through-hole 6 is pre-formed is bonded to the ceramic substrate 2. In a second method, a metal plate in which multiple metal circuits 3 are formed as one piece by bridges is prepared. The through-hole 6 is formed in the metal plate; and the metal plate is bonded to the ceramic substrate 2. The bridges are removed after bonding. Machining by stamping, electric discharge machining, drilling, etc., can be used to form the through-hole. At this time, it is favorable to adjust the ratio (*D2*/*D1*) of the dimension D2 to the dimension D1 by cutting the second end portion 6b side.

In contrast, when the through-hole 6 is formed by etching the metal plate, the metal plate dissolves along crystal grain boundaries of the metal plate. The dissolving by etching proceeds not only in the thickness direction (the first direction d1), but also in a planar direction parallel to the thickness direction. When etching a thick metal circuit 3, the etching proceeds in the planar direction; and side etching occurs. Due to the side etching, the side surface of the through-hole 6 becomes oblique to the first direction d1. In other words, the dimension D1 becomes excessively large relative to the dimension D2. Therefore, from the perspective of controlling the ratio (*D2*/*D1*), it is unfavorable to form the through-hole 6 by etching.

A semiconductor element and the like are bonded to the metal circuit 3 when the ceramic circuit board 1 is used in an application such as a power module, etc. To reduce the thermal resistance and reduce the inductance, it is favorable for the thickness of the metal circuit 3 to be not less than 1.0 mm. The thickness of the metal circuit 3 is more favorably not less than 2.0 mm, and most favorably not less than 3.0 mm.

The metal heat dissipation plate 5 is used as a heat dissipation member, and is bonded to other components. To reduce the thermal resistance, it is favorable for the thickness of the metal heat dissipation plate 5 to be not less than 1.0 mm. The thickness of the metal heat dissipation plate 5 is more favorably not less than 2.0 mm, and most favorably not less than 3.0 mm. Although the upper limit of the thickness of the metal circuit 3 and the upper limit of the thickness of the metal heat dissipation plate 5 are not particularly limited, it is favorable for each to be not more than 10 mm. If the thickness of the metal circuit 3 or the metal heat dissipation plate 5 is greater than 10 mm, there is a possibility that stress may concentrate at the bonding interface; and cracks may occur in the ceramic substrate 2. As a result, there is a possibility that it may be difficult to make the ceramic substrate 2 thin.

FIG. 4 is a cross-sectional view showing another example of a ceramic circuit board according to an embodiment. FIG. 5 is a plan view showing the other example of the ceramic circuit board according to the embodiment. FIG. 4 corresponds to a B-B cross-sectional view of FIG. 5. In FIG. 4, 7 is a ceramic circuit board, and 8 is a metal pin. In the ceramic circuit board 7 shown in FIGS. 4 and 5, the metal pin 8 is inserted into the through-hole 6 of the metal circuit 3. The metal pin 8 is bonded to the ceramic substrate 2 via the active metal brazing material layer 4.

It is favorable for the metal circuit 3, the metal heat dissipation plate 5, and the metal pin 8 to include copper or a copper alloy. Copper and copper alloys have high electrical conductivity and are excellent as materials of electrical circuits. Also, copper and copper alloys have high thermal conductivity and can improve the heat dissipation of the mounted semiconductor element.

The shape of the metal pin 8 is, for example, columnar or prismatic. When the metal pin 8 is columnar, the shape of the cross section of the metal pin 8 perpendicular to the first direction d1 is a circle or an ellipse. When the metal pin 8 is prismatic, the shape of the cross section of the metal pin 8 perpendicular to the first direction d1 is polygonal. As described above, the shape of the through-hole 6 when viewed in plan may be circular, elliptical, or polygonal. The shape of the through-hole 6 and the shape of the metal pin 8 when viewed in plan may be different from each other. However, in order to easily insert the metal pin 8 into the through-hole 6, it is favorable for the clearance between the through-hole 6 and the metal pin 8 at the outer perimeter of the metal pin 8 to be uniform. To increase the uniformity of the clearance, it is favorable for the shape of the insertion portion of the metal pin 8 to be substantially the same as the shape of the through-hole 6. For example, when the through-hole 6 is circular when viewed in plan, it is favorable for the cross-sectional shape of the insertion portion of the metal pin 8 to be circular.

The size of the metal pin 8 can be appropriately designed as long as the metal pin 8 can be inserted into the through-hole 6. As the ratio of the size of the metal pin 8 to the size of the through-hole 6 increases, the gap between the metal pin 8 and the side surface of the through-hole 6 decreases. As a result, the bonding strength of the metal pin 8 can be increased. On the other hand, if the gap is small, it may become difficult to insert the metal pin 8. For example, the dimension in the second direction d2 of the insertion portion of the metal pin 8 is designed to be not less than 0.7 times and not more than 0.98 times the dimension D1. It is favorable for the dimension of the insertion portion to be not less than 0.75 times and not more than 0.97 times the dimension D1, more favorably not less than 0.8 times and not more than 0.96 times the dimension D1, and most favorably not less than 0.85 times and not more than 0.95 times the dimension D1.

It is favorable for the metal circuit 3 and the metal heat dissipation plate 5 to be bonded to the ceramic substrate 2 via the active metal brazing material layer 4. It is favorable for the active metal brazing material layer 4 to include at least one active metal selected from the group consisting of titanium (Ti), zirconium (Zr), hafnium (Hf), and niobium (Nb), and at least one selected from the group consisting of silver (Ag), copper (Cu), tin (Sn), indium (In), zinc (Zr), aluminum (Al), silicon (Si), carbon (C), and magnesium (Mg).

When the metal circuit 3 and the metal heat dissipation plate 5 include copper or a copper alloy, it is favorable to provide the active metal brazing material layer 4 including copper and titanium between the ceramic substrate 2 and the metal circuit 3 and between the ceramic substrate 2 and the metal heat dissipation plate 5. The active metal brazing material layer 4 that includes copper and titanium is formed by bonding with an active metal brazing material including copper and titanium. A mixture of titanium, copper, and silver may be used as the active metal brazing material. For example, the content of titanium is 0.1 to 10 wt%; the content of copper is 10 to 60 wt%; and the remainder is silver. If necessary, one or more selected from the group consisting of indium, tin, aluminum, silicon, carbon, and magnesium may be added at 1 to 15 wt%.

In active metal bonding using an active metal brazing material, first, an active metal brazing material paste is coated onto the upper surface 2a and the lower surface 2b of the ceramic substrate 2. The metal circuit 3 and the metal heat dissipation plate 5 each are arranged on the active metal brazing material paste. The metal circuit 3 and the metal heat dissipation plate 5 are bonded to the ceramic substrate 2 by heating the ceramic substrate 2, the metal circuit 3, and the metal heat dissipation plate 5 at 600 to 900 °C. According to the active metal bonding, the bonding strength between the ceramic substrate 2 and the metal circuit 3 and the bonding strength between the ceramic substrate 2 and the metal heat dissipation plate 5 can be not less than 50 MPa.

A metal thin film that has one selected from the group consisting of nickel (Ni), silver, and gold (Au) as a major component may be formed on the surface of the metal circuit 3. "Major component" refers to the content of a component being not less than 50%. The metal thin film is formed by plating, sputtering, etc. The corrosion resistance, the solder wettability, etc., can be improved by including the metal thin film.

In recent years, semiconductor elements have become smaller, but the heat generation amount from semiconductor elements have increased. It is therefore important to improve the heat dissipation of the ceramic circuit board 1 to which the semiconductor element is mounted. Also, multiple semiconductor elements may be mounted on one ceramic circuit board 1 to increase the performance of the semiconductor device (the semiconductor module). When the temperature of any of the semiconductor elements rises and exceeds the intrinsic temperature of the element, the temperature coefficient of the resistance becomes negative. As a result, thermal runaway occurs, and concentrated current flows in the semiconductor element. When thermal runaway occurs, breakdown of the semiconductor device instantaneously occurs. When multiple semiconductor elements are mounted, it is necessary to prevent the occurrence of thermal runaway for each of the semiconductor elements. It is therefore extremely effective to increase the reliability of the bond between the metal circuit and the semiconductor elements.

A semiconductor device that uses the ceramic circuit board 7 according to the embodiment can be used in a PCU, an IGBT, or an IPM module. PCU, IGBT, and IPM modules are used in inverters. Inverters are used in automobiles (including electric vehicles), electric railway vehicles, industrial machinery, air conditioners, etc. Among automobiles, electric vehicles are becoming increasingly popular. The safety of an automobile can be increased as the reliability of the semiconductor device increases. This is similar for electric railway vehicles, industrial devices, etc.

According to the embodiment, the metal circuit 3 includes the through-hole 6; and the active metal brazing material layer 4 is present also at the portion of the upper surface 2a of the ceramic substrate 2 overlapping the through-hole 6. The metal pin 8 that is inserted into the through-hole 6 can be bonded to the ceramic substrate 2 by the active metal brazing material. Therefore, the metal pin 8 can be securely bonded to the ceramic substrate 2.

For example, as a reference example, it may be considered to bond the metal pin 8 and the ceramic substrate 2 by direct bonding (DBC) without using a brazing material. When, however, using DBC, only the end surface of the metal pin 8 is bonded to the ceramic substrate 2, and so sufficient strength is not obtained. Depending on the bonding position of the metal pin 8, there also may be cases where the metal pin 8 does not contact the side surface of the through-hole and is not electrically connected to the metal circuit 3.

A method for manufacturing a ceramic circuit board according to an embodiment will now be described. The method for manufacturing the ceramic circuit board is not particularly limited as long as the ceramic circuit board has the configuration described above. Here, an example of a method for obtaining the ceramic circuit board 7 with a high yield will be illustrated.

FIG. 6 is a flowchart showing an example of a method for manufacturing a ceramic circuit board according to an embodiment. As shown in FIG. 6, the manufacturing method M1 according to the embodiment mainly includes printing and drying an active metal brazing material (step S11), arranging a metal circuit (step S12), arranging a metal heat dissipation plate (step S13), bonding the metal circuit and the metal heat dissipation plate (step S14), inserting a metal pin (step S15), and bonding the metal pin (step S16).

First, a ceramic substrate and a metal plate are prepared. It is favorable for the ceramic substrate to be one type of substrate selected from an aluminum oxide substrate, an aluminum nitride substrate, and a silicon nitride substrate. In particular, when considering the heat dissipation of the entire circuit board, it is favorable for the ceramic substrate to be a silicon nitride substrate having a thermal conductivity of not less than 50 W/m·K and a three-point bending strength of not less than 600 MPa. A ceramic substrate that has a through-hole is prepared when the metal plate located at the upper surface of the ceramic substrate and the metal plate located at the lower surface of the ceramic substrate are to be electrically connected via a through-hole. When forming the through-hole in the ceramic substrate, the through-hole may be pre-formed in the compact stage. Or, the through-hole may be formed in the ceramic substrate (the ceramic sintered body). The through-hole is formed by laser patterning, cutting, etc. Cutting is, for example, boring by drilling, etc.

It is favorable for the material of the metal plate to be one selected from copper and copper alloys. The thickness of the metal plate is not less than 1 mm. When etching is not used, it is favorable to use a metal plate patterned into the shape of the metal circuit. When etching is used to form the metal circuit, it is favorable to use a metal plate with the same thickness as the metal circuit to be formed. The through-hole of the metal circuit (the metal plate) is formed by laser patterning, cutting, etc. Cutting is, for example, boring by drilling, etc.

It is favorable to bond the copper plate or the copper alloy plate to the ceramic substrate by active metal bonding. An active metal brazing material in which an active metal and copper are mixed is used in active metal bonding. It is favorable for the active metal to be titanium. The active metal brazing material may be a mixture of titanium and copper, or may be a mixture of titanium, silver, and copper. For example, in the active metal brazing material, the content of titanium is 0.1 to 10 wt%, the content of copper is 10 to 60 wt%, and the remainder is silver. If necessary, one or more selected from the group consisting of indium, tin, aluminum, silicon, carbon, and magnesium may be added at 1 to 15 wt%. A paste is formed by mixing the active metal brazing material component and an organic material. It is favorable to uniformly mix the active metal brazing material component in the paste. This is because if the active metal brazing material component is nonuniformly distributed, the brazing does not stabilize, which causes bonding defects.

In step S11, the active metal brazing material paste is printed and dried on the prepared ceramic substrate. As a result, a printed body is made on which the active metal brazing material paste is printed. As shown in FIGS. 1 and 2, it is favorable to print the active metal brazing material paste in a wider area than the metal circuit. At this time, the active metal brazing material paste is printed also at the portion of the upper surface 2a that will overlap the through-hole in the first direction d1.

In step S12, the metal circuit is arranged on the upper surface of the ceramic substrate with the active metal brazing material paste interposed. In step S13, the metal heat dissipation plate is arranged on the lower surface of the ceramic substrate with the active metal brazing material paste interposed. A stacked body is made by arranging the metal circuit and the metal heat dissipation plate. When a metal circuit is arranged at the lower surface as well, a metal circuit is arranged instead of the metal heat dissipation plate.

In step S14, the metal circuit and the metal heat dissipation plate are bonded to the ceramic substrate by heating the stacked body. As a result, a bonded body is made. When the metal circuit and the metal heat dissipation plate include copper or a copper alloy, the stacked body is heated at 700 to 900 °C. The heating process is performed in a vacuum or a nonoxidizing atmosphere as necessary. When the heating process is performed in a vacuum, it is favorable for the pressure to be not more than 1×10⁻² Pa. The nonoxidizing atmosphere is a nitrogen atmosphere, an argon atmosphere, etc. By heating the stacked body in a vacuum or a nonoxidizing atmosphere, oxidization of the bonding layer can be suppressed. As a result, the bonding strength can be increased.

When a circuit is to be formed by patterning by etching, the metal plate is arranged in step S12. A circuit configuration is patterned in the metal plate by etching the bonded metal plate after step S14.

The processes up to this point manufacture a ceramic circuit board that does not include a metal pin. In the ceramic circuit board, the metal circuit has a through-hole extending through the metal circuit along the first direction d1. A portion of the upper surface of the ceramic substrate overlaps the through-hole in the first direction d1. The active metal brazing material layer is present at the portion of the upper surface.

As shown in FIG. 6, the method for manufacturing the ceramic circuit board according to the embodiment may include a process of bonding a metal pin. In step S15, a metal pin is inserted into the through-hole of the metal circuit. The tip of the inserted metal pin contacts the active metal brazing material. The diameter of the metal pin is determined to match the shape of the through-hole formed in the metal circuit. For example, the metal pin has a slender columnar shape. Assembly is difficult when the clearance between the metal pin and the through-hole is small. However, a brazing material layer is easily formed between the metal pin and the through-hole; and the bonding strength is increased. Assembly is easy when the clearance between the metal pin and the through-hole is large. However, it is difficult to form the brazing material layer between the metal pin and the through-hole; and the bonding strength is reduced.

In step S16, the inserted metal pin is bonded to the ceramic substrate by heating the bonded body and the metal pin. When the metal pin includes copper or a copper alloy, the bonded body and the metal pin are heated at 700 to 900 °C. The metal pin is bonded to the ceramic substrate; and the ceramic circuit board shown in FIGS. 4 and 5 is manufactured.

FIG. 7 is a flowchart showing another example of a method for manufacturing a ceramic circuit board according to an embodiment. The manufacturing method M2 shown in FIG. 7 may be performed instead of the method shown in FIG. 6. The manufacturing method M2 shown in FIG. 7 mainly includes printing and drying an active metal brazing material (step S21), arranging a metal circuit and a metal pin (step S22), arranging a metal heat dissipation plate (step S23), and bonding (step S24).

First, similarly to the manufacturing method M1, the ceramic substrate and the metal plate are prepared. In step S21, the active metal brazing material paste is printed and dried on the ceramic substrate.

In step S22, the metal circuit and the metal pin are arranged on the upper surface of the ceramic substrate with the active metal brazing material paste interposed. According to the manufacturing method M1, the metal pin is arranged after bonding the metal circuit. In contrast, according to the manufacturing method M2, the metal pin is arranged before bonding the metal circuit. The metal circuit and the metal pin may be arranged at the same timing. The metal pin may be arranged by inserting into the through-hole of the metal circuit after the metal circuit is arranged. In step S23, the metal heat dissipation plate is arranged on the lower surface of the ceramic substrate with the active metal brazing material paste interposed. A stacked body that includes the metal pin is made by steps S22 and S23.

In step S24, the metal circuit, the metal pin, and the metal heat dissipation plate are bonded to the ceramic substrate by heating the stacked body. As a result, the ceramic circuit board shown in FIGS. 4 and 5 is manufactured.

When the metal circuit is formed by etching a metal plate, the manufacturing method M1 is favorable compared to the manufacturing method M2. This is because it is difficult to etch the metal plate if the metal pin is present when etching. Also, according to the manufacturing method M1, the metal circuit and the metal pin can be individually aligned when arranging. Therefore, according to the manufacturing method M1, compared to the manufacturing method M2, the positional accuracy of the metal pin with respect to the metal circuit is increased. On the other hand, the manufacturing method M2 has fewer processes than the manufacturing method M1. For example, according to the manufacturing method M2, a heating process for bonding is performed only once. Therefore, according to the manufacturing method M2, the cost can be reduced compared to the manufacturing method M1.

In the case where the manufacturing method M1 is performed, the active metal brazing material paste is melted by heat in step S14. Subsequently, the active metal brazing material layer is formed by solidifying the active metal brazing material paste by cooling. The metal pin is arranged on the active metal brazing material layer. The active metal brazing material layer that has been melted and solidified is more difficult to melt than the active metal brazing material paste before melting. Therefore, there is a possibility that the bonding strength between the ceramic substrate and the metal pin may be reduced. Methods to increase the bonding strength include a method of increasing the bonding temperature, and a method of adding a brazing material (e.g., silver brazing) to the bonding location of the metal pin. To increase the bonding strength between the ceramic substrate and the metal pin in the manufacturing method M1, the bonding temperature in step S16 may be set to be greater than the bonding temperature in step S14. For example, the bonding temperature in step S16 is set to be greater than the bonding temperature in step S14 by not less than 10 °C and not more than 30 °C.

In the method of increasing the bonding temperature of the metal pin, more of the active metal brazing material layer is melted and contributes to the bonding between the ceramic substrate and the metal pin. In the method of adding silver brazing, for example, a foil of BAg-8 (silver 72%-copper 28%) specified in JIS Z 3261 can be used. The foil is arranged at the bottom of the through-hole after bonding the metal circuit and the ceramic substrate. The metal pin is arranged on the ceramic substrate with the active metal brazing material layer and the foil interposed. By heating in this state, the foil is melted in addition to the active metal brazing material layer. The metal pin is bonded to the ceramic substrate by the active metal brazing material and the foil. Hereinafter, the brazing material that is added to the active metal brazing material layer also is referred to as a "filler brazing material".

FIG. 8 is an enlarged cross-sectional view showing an example of portion C of FIG. 4. In FIG. 8, 9 is a brazing material layer. In the example shown in FIG. 8, the brazing material layer 9 is a portion of the active metal brazing material layer 4. The active metal brazing material is melted when bonding the metal pin 8. A portion of the active metal brazing material penetrates the gap between the metal pin 8 and the side surface of the through-hole 6. As a result, the brazing material layer 9 is formed between the metal pin 8 and the side surface of the through-hole 6 in a direction perpendicular to the first direction d1. The metal pin 8 is bonded to the metal circuit 3 by the brazing material layer 9. As a result, the bonding strength of the metal pin 8 can be increased.

FIG. 9 is an enlarged cross-sectional view showing another example of portion C of FIG. 4. In the example shown in FIG. 9, the brazing material layer 9 is formed of a filler brazing material. By using the filler brazing material, the bonding area between the metal circuit 3 and the metal pin 8 is greater than that of the example shown in FIG. 8. Therefore, the bonding strength between the metal circuit 3 and the metal pin 8 can be further increased. For example, when a BAg-8 foil is used as the filler brazing material, the mass fraction of silver in the brazing material layer 9 is greater than the mass fraction of silver in the active metal brazing material layer 4. The mass fraction of the active metal in the brazing material layer 9 is less than the mass fraction of the active metal in the active metal brazing material layer 4.

FIG. 10 is an enlarged cross-sectional view showing an example of portion D of FIG. 8. In FIG. 10, 8a is the tip of the metal pin 8. It is favorable for the position in the first direction d1 of the tip 8a to be substantially the same as the position in the first direction d1 of the lower surface 3b of the metal circuit 3. When bonding, the active metal brazing material or the filler brazing material spreads by wetting between the metal pin 8 and the side surface of the through-hole 6. The metal circuit 3 and the metal pin 8 are bonded thereby.

A capillary phenomenon of the active metal brazing material or the filler brazing material occurs. As a result, as shown in FIG. 10, a portion of the brazing material layer 9 is low. As one specific example, one side portion of the brazing material layer 9 contacts the metal circuit 3. The other side portion of the brazing material layer 9 contacts the metal pin 8. The central portion of the brazing material layer 9 is positioned between the side portions of the brazing material layer 9. The upper end of the central portion of the brazing material layer 9 is positioned lower than the upper ends of the side portions of the brazing material layer 9.

The distance in the first direction d1 from the lower surface 3b of the metal circuit 3 to the upper end of the central portion of the brazing material layer 9 is referred to as a height H. It is favorable for the height H to be greater than 0 mm and not more than the dimension in the first direction d1 of the through-hole 6. In other words, it is favorable for the upper end of the brazing material layer 9 to be positioned between the lower end and the upper end of the through-hole 6. In other words, the dimension in the first direction d1 of the through-hole 6 is the thickness in the first direction d1 of the metal circuit 3. If the heating temperature when bonding is low, the active metal brazing material does not spread sufficiently inside the through-hole 6. If the heating temperature when bonding is low and a filler brazing material is not used, the brazing material layer 9 is not formed between the metal pin 8 and the side surface of the through-hole 6; and a sufficient bonding strength is not obtained. By forming the brazing material layer 9 between the metal pin 8 and the side surface of the through-hole 6 so that the height H is greater than 0 mm, the bonding strength between the metal circuit 3 and the metal pin 8 can be increased. It is favorable for the height H to be not less than 6% of the thickness of the metal circuit 3. The height H is more favorably not less than 10% of the thickness, and most favorably not less than 20% of the thickness. The bonding strength can be increased as the height H increases. From the perspective of the bonding strength, it is favorable for the height H to be 100%. On the other hand, when the height H is greater than the dimension of the through-hole 6, the active metal brazing material or the filler brazing material wets and spreads over the upper surface 3a of the metal circuit 3. This obstructs the bonding of a semiconductor element in a subsequent process. Considering fluctuation of the height H, the height H may be not more than 95% of the thickness of the metal circuit 3, not more than 90% of the thickness, or not more than 85% of the thickness.

FIG. 11 is an enlarged cross-sectional view showing another example of portion D of FIG. 8. The ratio (*D2*/*D1*) of the dimension D2 to the dimension D1 affects the height H. FIG. 11 shows an example in which the dimension D1 is less than the dimension D2. In other words, the ratio (*D2*/*D1*) of *D2* to *D1* is greater than 1.00.

When bonding, the active metal brazing material or the filler brazing material wets and spreads over the side surface of the through-hole 6 and the side surface of the metal pin 8. When the ratio (*D2*/*D1*) is greater than 1.00, the gap between the metal pin 8 and the side surface of the through-hole 6 becomes narrower upward. In other words, the gap is more easily filled with the active metal brazing material or the filler brazing material toward the top. The height H can increase easily, and the metal circuit 3 and the metal pin 8 can be more securely bonded.

FIG. 12 is an enlarged cross-sectional view showing a portion of a ceramic circuit board according to a reference example. FIG. 12 shows an example in which the dimension D1 is greater than the dimension D2. In other words, the ratio (*D2*/*D1*) of *D2* to *D1* is less than 1.00. In the example shown in FIG. 12, the gap between the metal pin 8 and the side surface of the through-hole 6 widens upward. The gap is difficult to fill with the brazing material when the brazing material wets and spreads between the metal pin 8 and the side surface of the through-hole 6. For example, as shown in FIG. 12, cases may occur where the brazing material wets and spreads over the side surface of the through-hole 6 and the side surface of the metal pin 8, but the gap is not filled. The portions that spread over the side surface of the through-hole 6 and the side surface of the metal pin 8 do not contribute much to the bonding strength between the metal circuit 3 and the metal pin 8. In other words, the height H greatly affects the bonding strength. In the example shown in FIG. 12, the brazing material wets and spreads, but the height H is small. Accordingly, when the ratio (*D2*/*D1*) is less than 1.00, the bonding strength between the metal circuit 3 and the metal pin 8 is easily reduced.

It is therefore favorable for the ratio (*D2*/*D1*) of the dimension D2 to the dimension D1 to be greater than 1.00. As long as *D2*/*D1* is greater than 1.00, the height H that contributes to the bonding can be large as shown in FIG. 11.

On the other hand, if *D2*/*D1* is greater than 1.10, the gap between the metal pin 8 and the side surface of the through-hole 6 at the second end portion 6b becomes large. The amount of the brazing material necessary to fill the gap is high. The height H is more easily reduced thereby. Accordingly, it is favorable for the ratio (*D2*/*D1*) to be greater than 1.00 and not more than 1.10. The ratio (*D2*/*D1*) is more favorably not less than 1.01 and not more than 1.09, and even more favorably not less than 1.02 and not more than 1.08.

FIG. 13 is an enlarged cross-sectional view showing another example of a ceramic circuit board according to an embodiment. The gap between the metal pin 8 and the side surface of the through-hole 6 may be adjusted by the ratio (*D2*/*D1*) as shown in FIG. 11. Or, the gap between the metal pin 8 and the side surface of the through-hole 6 may be adjusted by the shape of the metal pin 8 as shown in FIG. 13. In FIG. 13, the dimension in the second direction d2 of the metal pin 8 decreases downward. For example, the dimension in the second direction d2 of the metal pin 8 at the second end portion 6b is less than the dimension in the second direction d2 of the metal pin 8 at the first end portion 6a. Therefore, the gap between the metal pin 8 and the side surface of the through-hole 6 at the first end portion 6a is smaller than the gap between the metal pin 8 and the side surface of the through-hole 6 at the second end portion 6b.

According to the manufacturing method M2 shown in FIG. 7, as described above, the metal circuit 3 and the metal pin 8 are simultaneously bonded. If the clearance between the through-hole 6 and the metal pin 8 is appropriate, the brazing material wets and spreads easily between the metal pin 8 and the side surface of the through-hole 6 when bonding. Therefore, the bonding strength of the metal pin 8 can be increased even when a filler brazing material is not used.

The ceramic circuit board 7 according to the embodiment can be used in a power module, etc. A semiconductor element or the like is bonded to the metal pin 8 of the ceramic circuit board 7. When bonding the semiconductor element, a bonding layer is provided at the bonding location at the upper surface of the metal circuit 3. It is favorable for the bonding layer to include a brazing material, an electrically-conductive adhesive, etc. The necessary number of semiconductor elements is arranged on the bonding layer. An insulating resin may be provided around the semiconductor elements.

### (Examples 1 to 7, Comparative Examples 1 to 7, and Reference Example 1)

A silicon nitride substrate was prepared as a ceramic substrate for each of Examples 1 to 7, Comparative Examples 1 to 7, and Reference Example 1. The thicknesses of the silicon nitride substrates were as shown in Table 1. The thermal conductivity of the silicon nitride substrate was 90 W/m·K, and the three-point bending strength was 650 MP. The size of the ceramic substrate was 30 mm long×55 mm wide.

Copper plates having the thicknesses shown in Table 1 were prepared as the metal plates. In the examples other than Comparative Example 4, a 17 mm×17 mm copper plate was prepared as the metal circuit. A 17 mm long×44 mm wide copper plate was prepared as the metal heat dissipation plate. Two metal circuits and one metal heat dissipation plate were prepared for one silicon nitride substrate. In Comparative Example 4, a 30 mm long×55 mm wide copper plate was prepared as each of the metal circuit and the metal heat dissipation plate. One metal circuit and one metal heat dissipation plate were prepared for one silicon nitride substrate. In the examples other than Comparative Example 4, one through-hole was formed by machining in each metal circuit that was prepared. The diameter of the through-hole was about 1 mm. In Comparative Example 4, no through-hole was formed in any of the copper plates. A cylindrical copper member having a diameter of 1 mm (tolerance ±10%) was prepared as the metal pin.

Then, a brazing material paste for bonding the ceramic substrate and the metal plate of brazing was made. An active metal brazing material was used in the bonding. In the active metal brazing material, the content of titanium was 2 wt%, the content of tin was 10 wt%, the content of copper was 30 wt%, and the remainder was silver. A brazing material paste was made by mixing organic components with powders of these raw materials. The brazing material paste was printed and dried on two surfaces of the ceramic substrate. For Comparative Examples 1 to 3, the brazing material paste was not printed on locations that would face the through-holes after assembly, but for the other examples, the brazing material paste was printed also at the locations that would face the through-holes after assembly. Table 1 lists these conditions in the column "printed at through-hole".

A stacked body was made by arranging the metal plate on the dried brazing material paste. In some of the examples, the metal pin was arranged simultaneously with the metal plate. Bonding was performed by heating the stacked body in a vacuum (not more than 1×10⁻² Pa) at a bonding temperature of not less than 830 °C for 10 minutes. In some of the examples, a filler brazing material was used when bonding. Table 1 lists these conditions in the column "pin bonding method". Table 1 lists examples in which the metal pin was arranged and bonded after bonding the metal plate as "after bonding". Examples in which the metal plate and the metal pin were bonded simultaneously with the ceramic substrate are listed as "simultaneous with bonding". Examples having the condition of "after bonding" together with a 0.01 g silver brazing (BAg-8) foil being used as a filler brazing material are listed as "brazing material bonding". The filler brazing material was arranged at the bottom portion of the through-hole before arranging the metal pin. In Comparative Example 4, the through-hole was formed by etching after bonding the metal plate to the ceramic substrate. The metal pin was inserted into the through-hole that was formed, and the metal pin was bonded.

Also, Table 1 lists the temperature when bonding the metal plate in the column "bonding temperature", and lists the temperature when bonding the metal pin in the column "pin bonding temperature". In the condition "simultaneous with bonding", the bonding temperature of the metal plate and the bonding temperature of the metal pin were the same value because the metal plate and the metal pin were simultaneously bonded. In Reference Example 1, the metal pin was bonded at a pin bonding temperature of 780 °C.

**[Table 1]**

| | Substrate thickness (mm) | Metal plate thickness (mm) | Printed at through-hole | Bonding temperature (°C) | Pin bonding method | Pin bonding temperature (°C) |
|---|---|---|---|---|---|---|
| Example 1 | 0.32 | 1.0 | Printed | 830 | After bonding | 830 |
| Example 2 | 0.32 | 1.0 | Printed | 840 | After bonding | 830 |
| Example 3 | 0.32 | 1.0 | Printed | 820 | After bonding | 820 |
| Example 4 | 0.32 | 1.0 | Printed | 830 | Simultaneous with bonding | 830 |
| Example 5 | 0.32 | 1.0 | Printed | 830 | Brazing material bonding | 830 |
| Example 6 | 0. 64 | 1.0 | Printed | 830 | After bonding | 830 |
| Example 7 | 0.64 | 2.0 | Printed | 830 | After bonding | 830 |
| Comparative Example 1 | 0.32 | 1.0 | No | 830 | After bonding | 830 |
| Comparative Example 2 | 0.32 | 1.0 | No | 830 | Simultaneous with bonding | 830 |
| Comparative Example 3 | 0.32 | 1.0 | No | 830 | Brazing material bonding | 830 |
| Comparative Example 4 | 0.32 | 1.0 | Printed | 830 | After bonding | 830 |
| Comparative Example 5 | 0.32 | 1.0 | Printed | 830 | After bonding | 830 |
| Comparative Example 6 | 0.32 | 1.0 | Printed | 810 | After bonding | 810 |
| Comparative Example 7 | 0.64 | 2. 0 | Printed | 830 | After bonding | 830 |
| Reference Example 1 | 0.32 | 1.0 | Printed | 810 | After bonding | 780 |

After the metal pin was bonded, the ceramic circuit board was cut through the central portion of the through-hole. The cross section was observed, and the dimension D1 and the dimension D2 were measured. The ratio (*D2*/*D1*) was calculated. Also, the height H at the central portion of the brazing material inside the through-hole was measured. The results are shown in Table 2.

Also, the pull strength was measured as the bonding strength of the metal pin. To measure the pull strength, the ceramic circuit board was fixed to a jig; and the tip of the metal pin was pulled in a direction perpendicular to the ceramic substrate surface at a rate of 50 mm/min. The strength when the metal pin detached from the ceramic circuit board was measured. The measurement results of the bonding strength also are listed in Table 2. In Reference Example 1, the metal pin could not be bonded, and the bonding strength could not be measured. This was because the temperature when bonding the metal pin was less than the melting temperature of the active metal brazing material.

**[Table 2]**

| | D1 (mm) | D2 (mm) | D2/D1 | Height H (mm) | Bonding strength (N) |
|---|---|---|---|---|---|
| Example 1 | 1.00 | 1.05 | 1.05 | 0.15 | 32 1 |
| Example 2 | 0.98 | 1.07 | 1.09 | 0.16 | 33.0 |
| Example 3 | 1.02 | 1.03 | 1.01 | 0.27 | 41.2 |
| Example 4 | 1.00 | 1.05 | 1.05 | 0.15 | 32.2 |
| Example 5 | 0.99 | 1.06 | 1.07 | 0.92 | 96.2 |
| Example 6 | 1.00 | 1.07 | 1.07 | 0.16 | 32.0 |
| Example 7 | 1.03 | 1.05 | 1.02 | 0.20 | 35.4 |
| Comparative Example 1 | 0.99 | 1.05 | 1.06 | 0.00 | 2.3 |
| Comparative Example 2 | 1.00 | 1.04 | 1.04 | 0.00 | 4.2 |
| Comparative Example 3 | 1.00 | 1.05 | 1.05 | 0. 55 | 10.6 |
| Comparative Example 4 | 1.00 | 1.20 | 1.20 | 0.01 | 18.5 |
| Comparative Example 5 | 1.00 | 1.12 | 1. 12 | 0.05 | 19.3 |
| Comparative Example 6 | 0.99 | 0.98 | 0.99 | 0.02 | 19.4 |
| Comparative Example 7 | 1.00 | 1.16 | 1. 16 | 0.05 | 122 |
| Reference Example 1 | 1.00 | 1.04 | 1.04 | 0.00 | - |

The height H was greater than 0 mm for each cross section of the ceramic circuit boards according to Examples 1 to 7. In Examples 1 to 7, the brazing material paste was printed also at the location facing the through-hole. It is therefore considered that the brazing material paste melted when bonding the metal pin, and the melted brazing material paste rose through the gap between the metal pin and the side surface of the through-hole. In particular, in Example 5 that used a filler brazing material, the height H reached 92% of the thickness of the copper plate. On the other hand, in Comparative Examples 1 to 3, the brazing material paste was not printed at the location facing the through-hole. In the cross sections of the ceramic circuit boards according to Comparative Examples 1 and 2, the active metal brazing material did not rise through the interior of the through-hole; and only a portion of the tip of the metal pin was observed to be bonded to the ceramic substrate. In the cross section of the ceramic circuit board according to Comparative Example 3 as shown in FIG. 14, the brazing material layer rose through the interior of the through-hole, but the active metal brazing material was not observed in the greater part of the bonding location between the tip of the metal pin and the surface of the ceramic substrate.

Also, in the ceramic circuit board according to Examples 1 to 7, the ratio (*D2*/*D1*) of the dimension D2 to the dimension D1 was within the favorable range. Also, in Examples 1 to 7, the height H was within the favorable range. In Examples 1 to 7, high bonding strengths not less than 30 N were obtained. This was because the tip of the metal pin had a good bond to the ceramic substrate via the active metal brazing material. Also, this was because the metal pin had a good bond to the metal plate because the ratio (*D2*/*D1*) was within the favorable range. In particular, the bonding strength was greater than 40 N in Example 3; and the bonding strength was greater than 90 N in Example 5.

On the other hand, in Comparative Examples 1 to 7, the bonding strength was less than 20 N. In Comparative Examples 1, 2, and 4 to 7, the height H was not more than 5% of the thickness of the metal plate. In Comparative Examples 4 to 7, the ratio (*D2*/*D1*) was outside the favorable range. As a result, a sufficient height H could not be obtained, and the bonding strength between the metal plate and the metal pin was reduced. In Comparative Examples 1 to 3, the ceramic substrate was bonded via the active metal brazing material at only a portion of the tip of the metal pin; and the bonding strength was reduced. In particular, in Comparative Examples 1 and 2, the bonding strength was less than 5 N. This was because, at the location facing the through-hole, the brazing material paste was not printed and the filler brazing material was not used.

Embodiments of the invention include the following features.

### Feature 1

A ceramic circuit board, comprising:
a ceramic substrate; and
a metal circuit bonded to a first surface of the ceramic substrate via an active metal brazing material layer,
a thickness of the metal circuit being not less than 1 mm,
the metal circuit having a through-hole extending through the metal circuit along a first direction perpendicular to the first surface,
a portion of the first surface overlapping the through-hole in the first direction,
the active metal brazing material layer being present at the portion of the first surface.

### Feature 2

The ceramic circuit board according to Feature 1, wherein
the through-hole includes:
   a first end portion positioned at an upper surface of the metal circuit; and
   a second end portion facing the active metal brazing material layer, and
a ratio (*D2*/*D1*) of a dimension (D2) of the second end portion in a second direction to a dimension (D1) of the first end portion in the second direction is greater than 1.00 and not more than 1.10, the second direction being parallel to the first surface.

### Feature 3

The ceramic circuit board according to any one of Feature 1 or 2, further comprising:
a metal pin bonded to the portion of the first surface via the active metal brazing material layer.

### Feature 4

The ceramic circuit board according to Feature 3, further comprising:
a brazing material layer located between the metal pin and a side surface of the through-hole,
an upper end of the brazing material layer being positioned between a lower end and an upper end of the through-hole.

### Feature 5

The ceramic circuit board according to any one of Features 1 to 4, wherein
the ceramic substrate is one of an aluminum oxide substrate, an aluminum nitride substrate, or a silicon nitride substrate.

### Feature 6

The ceramic circuit board according to Feature 5, wherein
a thickness of the ceramic substrate is not more than 0.7 mm.

### Feature 7

The ceramic circuit board according to Feature 5 or 6, wherein
the metal circuit is made of one of copper or a copper alloy.

### Feature 8

The ceramic circuit board according to any one of Features 5 to 7, wherein
the active metal brazing material layer includes:
at least one selected from the group consisting of titanium, zirconium, hafnium, and niobium; and
at least one selected from the group consisting of silver, copper, tin, indium, zinc, aluminum, silicon, carbon, and magnesium.

### Feature 9

A method for manufacturing a ceramic circuit board, the method comprising:
printing and drying an active metal brazing material on each of a first surface and a second surface of a ceramic substrate;
arranging a metal circuit on the first surface with the active metal brazing material interposed, the metal circuit having a through-hole;
arranging a metal heat dissipation plate on the second surface with the active metal brazing material interposed;
bonding the metal circuit and the metal heat dissipation plate to the ceramic substrate;
inserting a metal pin into the through-hole of the bonded metal circuit; and
bonding the metal pin to the ceramic substrate.

### Feature 10

A method for manufacturing a ceramic circuit board, the method comprising:
printing and drying an active metal brazing material on each of a first surface and a second surface of a ceramic substrate;
arranging a metal circuit and a metal pin on the first surface with the active metal brazing material interposed, the metal circuit having a through-hole, the metal pin being inserted into the through-hole;
arranging a metal heat dissipation plate on the second surface with the active metal brazing material interposed; and
bonding the metal circuit, the metal pin, and the metal heat dissipation plate to the ceramic substrate.

### Feature 11

The method for manufacturing the ceramic circuit board according to Feature 9 or 10, wherein
the through-hole includes:
   a first end portion positioned at a surface of the metal circuit; and
   a second end portion facing the active metal brazing material layer, and
a ratio (*D2*/*D1*) of a dimension (*D2*) of the second end portion in a second direction to a dimension (D1) of the first end portion in the second direction is greater than 1.00 and not more than 1.10, the second direction being parallel to the first surface.

While certain embodiments of the inventions have been illustrated, these embodiments have been presented by way of example only, and are not intended to limit the scope of the inventions. These novel embodiments may be embodied in a variety of other forms; and various omissions, substitutions, modifications, etc., can be made without departing from the spirit of the inventions. These embodiments and their modifications are within the scope and spirit of the inventions, and are within the scope of the inventions described in the claims and their equivalents. Also, the embodiments above can be implemented in combination with each other.

### [Reference Numeral List]

1 ceramic circuit board
2 ceramic substrate
2a upper surface of ceramic substrate
2b lower surface of ceramic substrate
3 metal circuit
3a upper surface of metal circuit
3b lower surface of metal circuit
4 active metal brazing material layer
5 metal heat dissipation plate
6 through-hole
6a first end portion
6b second end portion
7 ceramic circuit board having metal pin bonded thereto
8 metal pin
8a tip of metal pin
9 brazing material layer

## Claims

1. A ceramic circuit board, comprising:
a ceramic substrate; and
a metal circuit bonded to a first surface of the ceramic substrate via an active metal brazing material layer,
a thickness of the metal circuit being not less than 1 mm,
the metal circuit having a through-hole extending through the metal circuit along a first direction perpendicular to the first surface,
a portion of the first surface overlapping the through-hole in the first direction,
the active metal brazing material layer being present at the portion of the first surface.

2. The ceramic circuit board according to claim 1, wherein
the through-hole includes:
a first end portion positioned at an upper surface of the metal circuit; and
a second end portion facing the active metal brazing material layer, and
a ratio (*D2*/*D1*) of a dimension (*D2*) of the second end portion in a second direction to a dimension (*D1*) of the first end portion in the second direction is greater than 1.00 and not more than 1.10, the second direction being parallel to the first surface.

3. The ceramic circuit board according to any one of claim 1 or 2, further comprising:
a metal pin bonded to the portion of the first surface via the active metal brazing material layer.

4. The ceramic circuit board according to claim 3, further comprising:
a brazing material layer located between the metal pin and a side surface of the through-hole,
an upper end of the brazing material layer being positioned between a lower end and an upper end of the through-hole.

5. The ceramic circuit board according to claim 1 or 2, wherein
the ceramic substrate is one of an aluminum oxide substrate, an aluminum nitride substrate, or a silicon nitride substrate.

6. The ceramic circuit board according to claim 5, wherein
a thickness of the ceramic substrate is not more than 0.7 mm.

7. The ceramic circuit board according to claim 5, wherein
the metal circuit is made of one of copper or a copper alloy.

8. The ceramic circuit board according to claim 5, wherein
the active metal brazing material layer includes:
at least one selected from the group consisting of titanium, zirconium, hafnium, and niobium; and
at least one selected from the group consisting of silver, copper, tin, indium, zinc, aluminum, silicon, carbon, and magnesium.

9. A method for manufacturing a ceramic circuit board, the method comprising:
printing and drying an active metal brazing material on each of a first surface and a second surface of a ceramic substrate;
arranging a metal circuit on the first surface with the active metal brazing material interposed, the metal circuit having a through-hole;
arranging a metal heat dissipation plate on the second surface with the active metal brazing material interposed;
bonding the metal circuit and the metal heat dissipation plate to the ceramic substrate;
inserting a metal pin into the through-hole of the bonded metal circuit; and
bonding the metal pin to the ceramic substrate.

10. A method for manufacturing a ceramic circuit board, the method comprising:
printing and drying an active metal brazing material on each of a first surface and a second surface of a ceramic substrate;
arranging a metal circuit and a metal pin on the first surface with the active metal brazing material interposed, the metal circuit having a through-hole, the metal pin being inserted into the through-hole;
arranging a metal heat dissipation plate on the second surface with the active metal brazing material interposed; and
bonding the metal circuit, the metal pin, and the metal heat dissipation plate to the ceramic substrate.

11. The method for manufacturing the ceramic circuit board according to claim 9 or 10, wherein
the through-hole includes:
a first end portion positioned at a surface of the metal circuit; and
a second end portion facing the active metal brazing material layer, and
a ratio (*D2*/*D1*) of a dimension (*D2*) of the second end portion in a second direction to a dimension (*D1*) of the first end portion in the second direction is greater than 1.00 and not more than 1.10, the second direction being parallel to the first surface.

## Amended claims

### Amended claims under Art. 19.1 PCT

1. [Amended] A ceramic circuit board, comprising:
a ceramic substrate; and
a metal circuit bonded to a first surface of the ceramic substrate via an active metal brazing material layer,
a thickness of the metal circuit being not less than 1 mm, the metal circuit having a through-hole extending through the metal circuit along a first direction perpendicular to the first surface,
a portion of the first surface overlapping the through-hole in the first direction,
the active metal brazing material layer being present at the portion of the first surface,
the through-hole including
a first end portion positioned at an upper surface of the metal circuit, and
a second end portion facing the active metal brazing material layer,
a ratio (*D2*/*D1*) of a dimension (*D2*) of the second end portion in a second direction to a dimension (*D1*) of the first end portion in the second direction being greater than 1.00 and not more than 1.10, the second direction being parallel to the first surface.

2. [Amended] A ceramic circuit board, comprising:
a ceramic substrate; and
a metal circuit bonded to a first surface of the ceramic substrate via an active metal brazing material layer,
a thickness of the metal circuit being not less than 1 mm,
the metal circuit having a through-hole extending through the metal circuit along a first direction perpendicular to the first surface,
a portion of the first surface overlapping the through-hole in the first direction,
the active metal brazing material layer being present at the portion of the first surface,
a solidus temperature of the active metal brazing material layer is not more than 830 °C.

3. [Amended] The ceramic circuit board according to claim 1 or 2, further comprising:
a metal pin bonded to the portion of the first surface via the active metal brazing material layer.

4. [Amended] The ceramic circuit board according to claim 3, wherein
the active metal brazing material layer has an interface contacting the metal pin.

5. [Amended] The ceramic circuit board according to claim 3, comprising:
a brazing material layer located between the metal pin and a side surface of the through-hole,
the brazing material layer having at least a portion including an active metal brazing material,
an upper end of the brazing material layer being positioned between a lower end and an upper end of the through-hole.

6. [Amended] The ceramic circuit board according to claim 5, wherein
a height of the brazing material layer is not less than 6% of a thickness of the metal circuit.

7. [Amended] The ceramic circuit board according to claim 1, wherein
a dimension in the second direction of an insertion portion of the metal pin is not less than 0.7 times a dimension in the second direction of the first end portion of the through-hole.

8. [Amended] The ceramic circuit board according to claim 1 or 2, wherein
the ceramic substrate is one of an aluminum oxide substrate, an aluminum nitride substrate, or a silicon nitride substrate.

9. [Amended] The ceramic circuit board according to claim 8, wherein
a thickness of the ceramic substrate is not more than 0.7 mm.

10. [Amended] The ceramic circuit board according to claim 8, wherein
the metal circuit is made of one of copper or a copper alloy.

11. [Amended] The ceramic circuit board according to claim 8, wherein
the active metal brazing material layer includes:
at least one selected from the group consisting of titanium, zirconium, hafnium, and niobium; and
at least one selected from the group consisting of silver, copper, tin, indium, zinc, aluminum, silicon, carbon, and magnesium.

12. [New] A method for manufacturing a ceramic circuit board, the method comprising:
arranging an active metal brazing material on at least a first surface of a ceramic substrate;
arranging a metal circuit on the first surface with the active metal brazing material interposed, the metal circuit having a through-hole;
bonding the metal circuit to the ceramic substrate by the active metal brazing material;
inserting a metal pin into the through-hole of the bonded metal circuit; and
bonding the metal pin to the ceramic substrate by the active metal brazing material.

13. [New] A method for manufacturing a ceramic circuit board, the method comprising:
arranging an active metal brazing material on at least a first surface of a ceramic substrate;
arranging a metal circuit and a metal pin on the first surface with the active metal brazing material interposed, the metal circuit having a through-hole, the metal pin being inserted into the through-hole; and
bonding the metal circuit and the metal pin to the ceramic substrate by the active metal brazing material.

14. [New] The method for manufacturing the ceramic circuit board according to claim 12 or 13, wherein
the through-hole includes:
a first end portion positioned at a surface of the metal circuit; and
a second end portion facing the active metal brazing material layer, and
a ratio *(D2*/*D1)* of a dimension (*D2*) of the second end portion in a second direction to a dimension (*D1*) of the first end portion in the second direction is greater than 1.00 and not more than 1.10, the second direction being parallel to the first surface.

Statement under Art. 19.1 PCT

The invention according to Amended Claim 1 specifies that a through-hole includes a first end portion positioned at an upper surface of a metal circuit, and a second end portion facing an active metal brazing material layer; and that a ratio *(D2*/*D1)* of a dimension (D2) of the second end portion in a second direction to a dimension (*D1*) of the first end portion in the second direction is greater than 1.00 and not more than 1.10, wherein the second direction is parallel to a first surface.
   The Specification of the present application discloses, in paragraphs 0064 to 0068 and in comparisons between Examples and Comparative Examples in paragraph 0072 and onward, that the bonding strength is increased by setting the ratio (*D2*/*D1*) to be greater than 1.00 and not more than 1.10.
   Reference 1 describes a structure in which a "recessed portion" has "a reverse-tapered shape in which the tapered surfaces of the sidewall spread apart downward", but makes no mention of the shape of the through-hole as specified in Amended Claim 1, nor of the effect of increasing the bonding strength by employing such a shape of the through-hole.
   Therefore, we respectfully submit that the invention according to Amended Claim 1 has Novelty over the invention described in Reference 1.
The invention according to Amended Claim 2 specifies that the solidus temperature of the active metal brazing material layer is not more than 830 °C.
   Reference 1 describes "an AMB substrate with an interposed bonding layer containing silver (Ag) brazing or the like as a major material", but makes no mention of the solidus temperature of the brazing material layer.
   Therefore, we respectfully submit that the invention according to Amended Claim 2 has Novelty over the invention described in Reference 1.
